# EUROPEAN PATENT APPLICATION

(11) **EP 3 032 589 A2**
(43) Date of publication of application: **15.06.2016**
(21) Application number: 15187016.9
(22) Date of filing: 28.09.2015
(51) Int. Cl.: H01L 29/786

(54) **THIN FILM TRANSISTOR**

(30) Priority: 10.12.2014 KR 20140177373
(71) Applicant: Samsung Display Co., Ltd., Gyeonggi-do 17113 (KR)
(72) Inventor: Lee, Je Hun, 201-205 Seoul (KR); Chu, Byung Hwan, 708, 193 Seoul (KR)
(74) Representative: Dr. Weitzel & Partner

(57) **Abstract**

A thin film transistor having uniform electrical characteristics and reduced power consumption is presented. The thin film transistor includes a semiconductor layer, a first metal oxide layer coming in contact with the semiconductor layer and having thermal conductivity that is lower than the thermal conductivity of the semiconductor layer and a second metal oxide layer coming in contact with the first metal oxide layer and having thermal conductivity that is higher than the thermal conductivity of the first metal oxide layer.

## Description

### BACKGROUND

### 1. Field of the Invention

The invention relates to a thin film transistor.

### 2. Description of the Prior Art

In general, a flat panel display, such as a liquid crystal display or an organic light emitting display, includes a plurality of pairs of electric field generating electrodes and an electro-optical active layer provided between the pairs of electric field generating electrodes. The liquid crystal display includes a liquid crystal layer as the electro-optical active layer, and the organic light emitting display includes an organic light emitting layer as the electro-optical active layer.

One of the pair of electric field generating electrodes is connected to a typical switching element to receive an electrical signal, and the electro-optical active layer converts the electrical signal into an optical signal to display an image.

In a flat panel display, a thin film transistor (TFT) is used as a switching element, and signal lines, such as a gate line that transfers a scan signal for controlling the thin film transistor and a data line that transfers a signal to be applied to a pixel electrode, are provided in the flat panel display.

### SUMMARY

In one aspect, a thin film transistor disclosed herein has uniform electrical characteristics.

In another aspect, a thin film transistor disclosed herein has reduced power consumption.

Additional aspects and features of the inventive concept will be set forth in the description that follows and will become apparent to those having ordinary skill in the art based on the disclosure.

According to an embodiment, a thin film transistor includes a semiconductor layer, a first metal oxide layer in contact with the semiconductor layer and having thermal conductivity that is lower than the thermal conductivity of the semiconductor layer, and a second metal oxide layer in contact with the first metal oxide layer and having thermal conductivity that is higher than the thermal conductivity of the first metal oxide layer.

According to another embodiment, a thin film transistor includes a semiconductor layer, a first metal oxide layer in contact with the semiconductor layer and having thermal conductivity that is lower than the thermal conductivity of the semiconductor layer and a metal layer in contact with the first metal oxide layer.

The second metal oxide layer may have the thermal conductivity that is higher than the thermal conductivity of the semiconductor layer.

The thin film transistor may include a metal layer that contacts the second metal oxide layer.

The thin film transistor may further comprise a third metal oxide layer having thermal conductivity that is higher than the thermal conductivity of the first metal oxide layer. The metal layer may be arranged between the second metal oxide layer and the third metal oxide layer. The metal layer may be arranged between the first metal oxide layer and the third metal oxide layer.

The first metal oxide layer may have an etch rate that is higher than the etch rate of the semiconductor layer.

The second metal oxide layer may have an etch rate that is higher than the etch rate of the first metal oxide layer.

The metal layer may have an etch rate that is higher than the etch rate of the third metal oxide layer.

The third metal oxide layer may have an etch rate that is higher than the etch rate of the second metal oxide layer.

The first metal oxide layer may be made of a first material, the semiconductor layer is made of a second material, and the thin film transistor includes an intermixing layer in which the first material and the second material are mixed. The intermixing layer may have thermal conductivity that is lower than the thermal conductivity of the semiconductor layer.

The intermixing layer may be arranged between the semiconductor layer and the first metal oxide layer.

The semiconductor layer may include a channel portion and a peripheral portion that is arranged around the channel portion, and the first metal oxide layer contacts the peripheral portion without contacting the channel portion.

The thin film transistor may include a first metal oxide layer that contacts the channel portion.

The first metal oxide layer that contacts the channel portion may be thinner than the first metal oxide layer that contacts the peripheral portion.

The thin film transistor of the disclosure can show uniform electrical characteristics through improvement of the dispersion of the electrical characteristics.

The thin film transistor of the disclosure can reduce the power consumption.

The thin film transistor according to embodiments of the inventive concept can solve the problem of color fading inferiority of the display device.

The effects according to the inventive concept are not limited to the contents explicitly disclosed herein.

### BRIEF DESCRIPTION OF THE DRAWINGS

The above and other objects, features and advantages of the invention will be more apparent from the following detailed description taken in conjunction with the accompanying drawings, in which:
FIG. 1 is a schematic layout diagram of a thin film transistor substrate according to an embodiment of the disclosure;
FIG. 2 is a schematic cross-sectional view taken along line II-II' of FIG. 1; and
FIGS. 3, 4, 5, 6, 7, 8, 9, 10, and 11 are schematic cross-sectional views of a thin film transistor substrate according to another embodiment of the disclosure.

### DETAILED DESCRIPTION OF THE EMBODIMENTS

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey exemplary implementations to those skilled in the art.

In the drawing figures, the dimensions of elements and regions may be exaggerated for clarity of illustration. It will also be understood that when a layer or element is referred to as being "on" another element or substrate, it can be directly on the other element or substrate, or intervening elements may be present. Further, it will be understood that when an element is referred to as being "connected" or "coupled" to another element, it can be directly connected or coupled, or one or more intervening elements may also be present. In addition, it will also be understood that when a layer is referred to as being "between" two layers, it can be the only layer between the two layers, or one or more intervening layers may also be present. In contrast, when an element is referred to as being, e.g., "directly on," "directly connected to" or "directly coupled to", another element or layer, there are no intervening elements or layers present. As used herein, connected may refer to elements being physically, electrically and/or fluidly connected to each other.

Like reference numerals refer to like elements throughout. As used herein, the term "and/or" includes any and all combinations of one or more of the associated listed items.

It will be understood that, although the terms first, second, third, etc., may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of the embodiments.

Spatially relative terms, such as "below," "lower," "under," "above," "upper" and the like, may be used herein for ease of description to describe the relationship of one element or feature to another element(s) or feature(s) as illustrated in the figures. It will be understood that the spatially relative terms are intended to encompass different orientations of the device in use or operation, in addition to the orientation depicted in the figures. For example, if the device in the figures is turned over, elements described as "below" or "beneath" relative to other elements or features would then be oriented "above" relative to the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting. As used herein, the singular forms "a," "an" and "the" are intended to include the plural forms as well, unless the context clearly indicates otherwise. It will be further understood that the terms "comprises," "comprising," "includes" and/or "including," when used in this specification, specify the presence of stated features, integers, operations, elements, and/or components, but do not preclude the presence or addition of one or more other features, integers, steps, operations, elements, components, and/or groups thereof.

Hereinafter, embodiments of the invention will be described in detail with reference to the accompanying drawings.

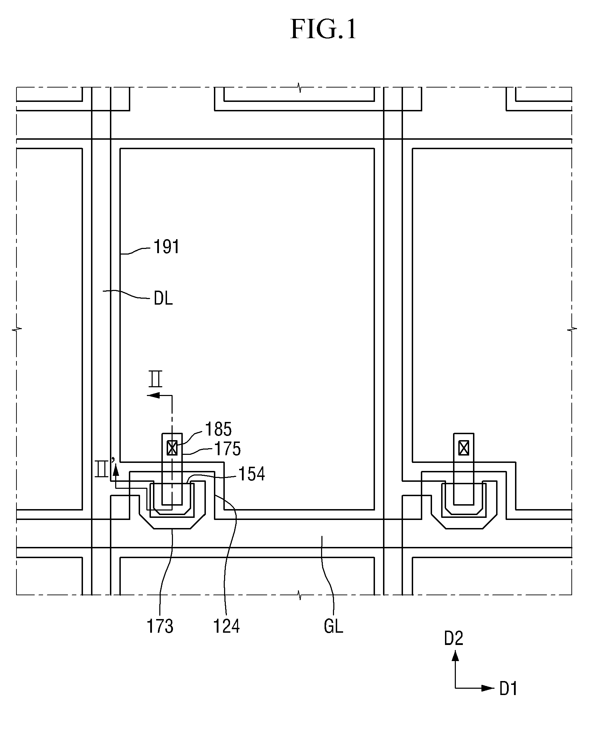

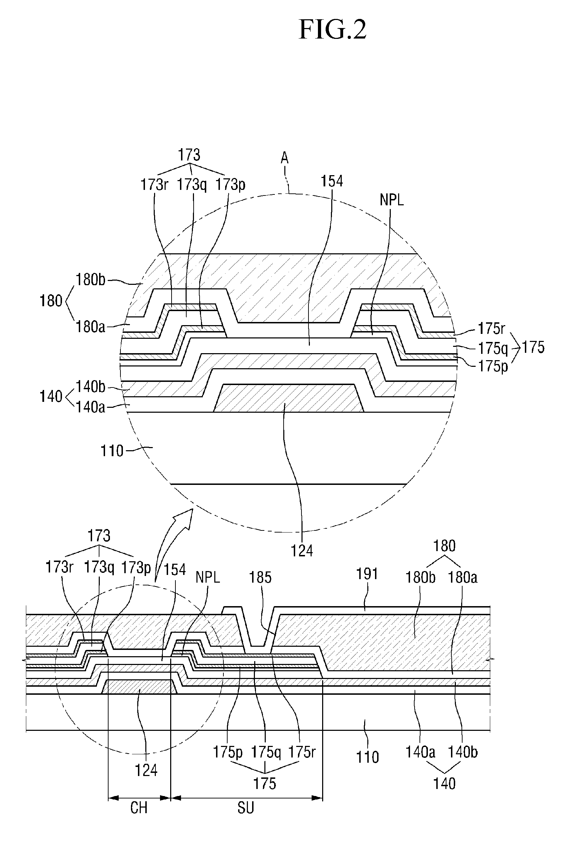

FIG. 1 is a schematic layout diagram of a thin film transistor substrate according to an embodiment of the invention, and FIG. 2 is a schematic cross-sectional view taken along line II-II' of FIG. 1.

Referring to FIGS. 1 and 2, a thin film transistor substrate according to an embodiment may include an insulating substrate 110, a gate line GL, a gate electrode 124, a gate insulating layer 140, a semiconductor layer 154, a data line DL, a first barrier layer NPL, a source electrode 173, a drain electrode 175, a passivation layer 180, and a pixel electrode 191. Each of the source electrode 173 and the drain electrode 175 may include a second barrier layer 173p or 175p that contacts the first barrier layer NPL, a metal layer 173q or 175q, and a capping layer 173r or 175r.

In the description, the first barrier layer NPL includes a first metal oxide, and may be referred to as the "first metal oxide layer." In the description, the second barrier layer 173p or 175p includes a second metal oxide, and may be referred to as the "second metal oxide layer." In the description, the capping layer 173r or 175r includes a third metal oxide, and may be referred to as the "third metal oxide layer."

The thin film transistor substrate may have a structure in which the gate line GL, the gate electrode 124, the gate insulating layer 140, the semiconductor layer 154, the first barrier layer NPL, the data line DL, the source electrode 173, the drain electrode 175, the passivation layer 180, and the pixel electrode 191 are successively laminated on the insulating substrate 110. Each of the source electrode 173 and the drain electrode 175 may have a structure in which the second barrier layer 173p or 175p, the metal layer 173q or 175q, and the capping layer 173r or 175r are successively laminated on the first barrier layer NPL.

The insulating substrate 110 may be formed of transparent glass or synthetic resin.

The gate line GL may transfer a gate signal, and may extend in a horizontal direction D1 on the insulating substrate 110. The gate electrode 124 may project from the gate line GL toward the pixel electrode 191. In an unlimited example, the gate line GL and the gate electrode 124 may be made of an aluminum based metal, such as aluminum (Al) or an aluminum alloy, a silver based metal, such as silver (Ag) or a silver alloy, a copper based metal, such as copper (Cu) or a copper alloy, a molybdenum based metal, such as molybdenum (Mo) or a molybdenum alloy, chrome (Cr), titanium (Ti), or tantalum (Ta).

The gate insulating layer 140 may be arranged on the insulating substrate 110 and the gate electrode 124. The gate insulating layer 140 may cover the whole surface of the gate line GL and the gate electrode 124. The gate insulating layer 140 may include a first insulating layer 140a and a second insulating layer 140b. In an unlimited example, the first insulating layer 140a may be thicker than the second insulating layer 140b. The first insulating layer 140a may be formed of silicon nitride (SiNx) with a thickness of about 4000Å, and the second insulating layer 140b may be formed of silicon oxide (SiO₂) with a thickness of about 500Å. In another unlimited example, the first insulating layer 140a may be made of silicon oxynitride (SiON), and the second insulating layer 140b may be made of silicon oxide (SiO₂). On the other hand, unlike what as illustrated, the gate insulating layer 140 may be composed of a single layer.

The semiconductor layer 154 may be arranged on the gate insulating layer 140. The semiconductor layer 154 may be arranged on an upper portion of the gate electrode 124. The semiconductor layer 154 may be arranged on lower portions of the source electrode 173 and the drain electrode 175. The semiconductor layer 154 may be arranged in a region that overlaps the gate electrode 124.

The semiconductor layer 154 may include a channel portion CH and a peripheral portion SU that is arranged on around the channel portion CH. The source electrode 173 and the drain electrode 175 may be arranged to be spaced apart from each other on the same plane. The channel portion CH is a region that is exposed between the source electrode 173 and the drain electrode 175, and the peripheral portion SU is a region that overlaps the source electrode 173 and the drain electrode 175. The channel portion CH may come in contact with the passivation layer 180.

The first barrier layer NPL may be arranged on the peripheral portion SU of the semiconductor layer 154. The first barrier layer NPL may come in contact with the peripheral portion SU of the semiconductor layer 154. The first barrier layer NPL may be made of a first material having thermal conductivity that is lower than the thermal conductivity of the semiconductor layer 154. The first barrier layer NPL can intercept transferring of heat that is generated in a process of manufacturing a thin film transistor to the semiconductor layer 154, and thus deterioration of the electrical characteristics of the thin film transistor can be prevented or minimized.

Specifically, in the case where the heat that is generated in the process of manufacturing a thin film transistor is transferred to the semiconductor layer 154, the threshold voltage of the thin film transistor may be changed from a predetermined value. For example, the threshold voltage of the thin film transistor may be changed from the predetermined value to a negative value. In this case, the function of the thin film transistor as a switching element is deteriorated.

The first barrier layer NPL may intercept the transferring of the heat that is generated in the process of manufacturing a thin film transistor to the semiconductor layer 154 to maintain the predetermined value of the threshold voltage of the thin film transistor. Accordingly, the electrical characteristics of the thin film transistor can be uniform.

The first material may be metal oxide having thermal conductivity that is lower than the thermal conductivity of a second material. In an unlimited example, the first material may include at least one of zinc (Zn), indium (In), tin (Sn), titanium (Ti), and gallium (Ga). In an unlimited example, the first material may be indium-gallium-zinc oxide (IGZO). In an unlimited example, the first material may be indium-tin-zinc oxide (ITZO).

The second material may include at least one of zinc (Zn), indium (In), tin (Sn), gallium (Ga), and titanium (Ti). In an unlimited example, the second material may be indium-tin-zinc oxide (ITZO).

On the other hand, the first material has an etch rate that is higher than the etch rate of the second material. If the first material had an etch rate that is lower than the etch rate of the second material, the process ability of an etching process for forming wirings and the channel portion CH may be deteriorated.

In the case where both the first material and the second material are made of indium-tin-zinc oxide (ITZO), the first material may have lower titanium (Ti) content than the titanium (Ti) content of the second material. In this case, in an unlimited example, a difference in titanium (Ti) between the first material and the second material may be equal to or higher than 3 wt%. In the case where the difference in titanium (Ti) between the first material and the second material is equal to or higher than 3 wt%, the first material has a higher etch rate than the etch rate of the second material.

The data line DL may transfer a data signal, and may extend in a vertical direction D2 on the insulating substrate 110. The source electrode 173 may project from the data line DL, and a part thereof may overlap the gate electrode 124. In an unlimited example, the source electrode 173 may be in a "U" shape as illustrated.

The drain electrode 175 is separated from the source electrode 173. A part of the drain electrode 175 may overlap the gate electrode 124. In an unlimited example, the drain electrode 175 may be arranged in a valley of the "U"-shaped source electrode 173. The drain electrode 175 may come in contact with the pixel electrode 191 through a contact hole 185.

Each of the source electrode 173 and the drain electrode 175 may have a structure in which the second barrier layer 173p or 175p, the metal layer 173q or 175q, and the capping layer 173r or 175r are successively laminated on the first barrier layer NPL. The metal layer 173q or 175q may be arranged between the capping layer 173r or 175r and the second barrier layer 173p or 175p.

The second barrier layer 173p or 175p may serve as a diffusion preventing layer that prevents metal components of the metal layer 173q or 175q from being diffused to the semiconductor layer 154. Further, the second barrier layer 173p or 175p may serve as an ohmic contact layer. The second barrier layer 173p or 175p may come in contact with the first barrier layer NPL.

The second barrier layer 173p or 175p may be made of a third material having thermal conductivity that is higher than the thermal conductivity of the second material. The third material may have higher thermal conductivity than the thermal conductivity of the first material. In other words, the second barrier layer 173p or 175p may have higher thermal conductivity than the thermal conductivity of the first barrier layer NPL or the semiconductor layer 154.

On the other hand, the third material has an etch rate that is higher than the etch rate of the first material. If the third material has an etch rate that is lower than the etch rate of the first material, the process ability of an etching process for forming wirings and the channel portion CH may be deteriorated.

In an unlimited example, the third material may be one of bare zinc oxide (ZnO), gallium-zinc oxide (GZO), aluminum-zinc oxide (AZO), and indium-zinc oxide (IZO).

A gallium-zinc oxide (GZO) layer may include 77.2 to 94.4 wt% of zinc oxide (ZnO) and 5.6 to 22.8 wt% of gallium (Ga). Gallium (Ga) or gallium oxide (Ga₂O₃) in the above-described content range may prevent the undercut to make the second barrier layer 173p or 175p function as a diffusion preventing layer, may prevent tailing that may be generated in the second barrier layer 173p or 175p during the etching process, and may prevent formation of a short circuit on the boundary of the channel portion CH of the semiconductor layer 154.

An aluminum-zinc oxide (AZO) layer may include 50 to 97.5 mol% of zinc oxide (ZnO) and 2.5 to 50 mol% of aluminum (Al). Aluminum (Al) or aluminum oxide (Al₂O₃) in the above-described content range may prevent undercut to make the second barrier layer 173p or 175p function as a diffusion preventing layer, may prevent tailing that may be generated in the second barrier layer 173p or 175p during the etching process, and may prevent formation of a short circuit on the boundary of the channel portion CH of the semiconductor layer 154.

An indium-zinc oxide (IZO) layer may include 10 to 97.5 wt% of zinc oxide (ZnO) and 2.5 to 90 wt% of indium (In). The indium-zinc oxide (IZO) layer may include 60 to 80 wt% of zinc oxide (ZnO) and 20 to 40 wt% of indium (In). Indium (In) or indium oxide (In₂O₃) in the above-described content range may prevent the undercut to make the second barrier layer 173p or 175p function as a diffusion preventing layer, may prevent tailing that may be generated in the second barrier layer 173p or 175p during the etching process, and may prevent formation of a short circuit on the boundary of the channel portion CH of the semiconductor layer 154.

The metal layer 173q or 175q serves as a main wiring layer for transferring the data signal. The metal layer 173q or 175q may come in contact with the second barrier layer 173p or 175p. In an unlimited example, the metal layer 173q and 175q may be made of nickel (Ni), cobalt (Co), titanium (Ti), silver (Ag), copper (Cu), molybdenum (Mo), aluminum (Al), beryllium (Be), niobium (Nb), gold (Au), or iron (Fe).

On the other hand, the metal layer 173q or 175q has an etch rate that is higher than the etch rate of the second barrier layer 173p or 175p. If the second barrier layer 173p or 175p has the etch rate that is higher than the etch rate of the metal layer 173q or 175q, the second barrier layer 173p or 175p may be over-etched, and the function of the second barrier layer 173p or 175p, which serves as a diffusion preventing layer that prevents metal components of the metal layer 173q or 175q from being diffused to the semiconductor layer 154, may be deteriorated.

The capping layer 173r or 175r may prevent oxidation of the metal layer 173q or 175q. The capping layer 173r or 175r may come in contact with the metal layer 173q or 175q. The capping layer 173r or 175r may be one of a gallium-zinc oxide (GZO) layer, an aluminum-zinc oxide (AZO) layer, and an indium-zinc oxide (IZO) layer.

On the other hand, the etch rate of the capping layer 173r or 175r is lower than the etch rate of the metal layer 173q or 175q, and is higher than the etch rate of the second barrier layer 173p or 175p. If the etch rate of the capping layer 173r or 175r is higher than the etch rate of the metal layer 173q or 175q, the function of the capping layer 173r or 175r, which prevents oxidation of the metal layer 173q or 175q, may be deteriorated.

The gallium-zinc oxide (GZO) layer may include 70 to 85 wt% of zinc oxide (ZnO) and 15 to 30 wt% of gallium (Ga). The aluminum-zinc oxide (AZO) layer may include 70 to 85 wt% of zinc oxide (ZnO) and 15 to 30 wt% of aluminum (Al). The indium-zinc oxide (IZO) layer may include 70 to 85 wt% of zinc oxide (ZnO) and 15 to 30 wt% of indium (In). The gallium-zinc oxide (GZO) layer, the aluminum-zinc oxide (AZO) layer, and the indium-zinc oxide (IZO) layer may respectively prevent oxidation of the metal layer 173r or 175r within the above-described component content range.

The passivation layer 180 may be made of inorganic insulator, such as silicon nitride or silicon oxide, organic insulator or low-k insulator. The passivation layer 180 may include a first passivation layer 180a and a second passivation layer 180b. In an unlimited example, the first passivation layer 180a may be made of silicon oxide, and the second passivation layer 180b may be made of silicon nitride. The pixel electrode 191 may be arranged on the passivation layer 180.

The pixel electrode 191 may be arranged in a region in which the gate line GL and the data line DL cross each other. In an unlimited example, the pixel electrode 191 may be a transparent electrode that is made of indium-tin oxide (ITO) or indium-zinc oxide (IZO). The pixel electrode 191 receives the data voltage from the drain electrode 175 through the contact hole 185.

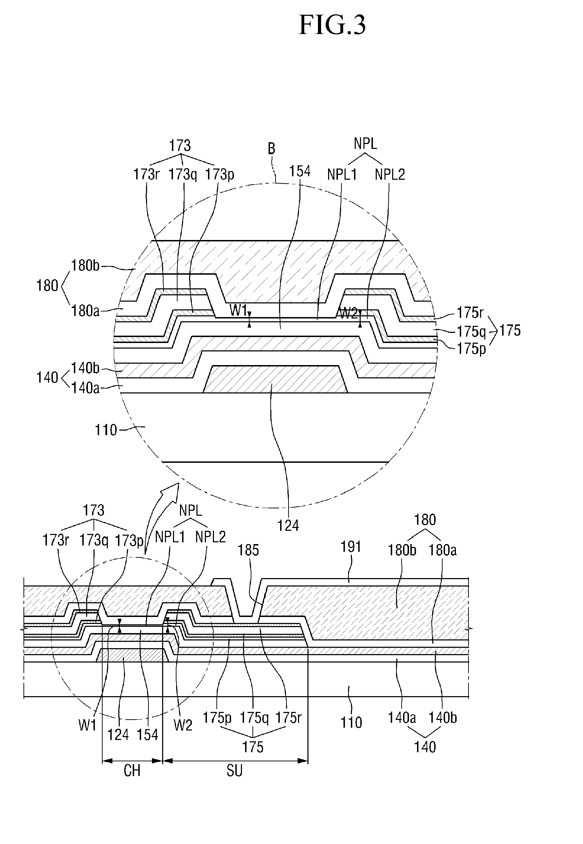

FIGS. 3 to 11 are schematic cross-sectional views of a thin film transistor substrate according to another embodiment.

Referring to FIG. 3, a thin film transistor of FIG. 3 is different from the thin film transistor of FIG. 2 on the point that the first barrier layer NPL is formed in the channel portion CH. According to the thin film transistor of FIG. 2, the first barrier layer NPL is formed only on the peripheral portion SU, and thus the first barrier layer NPL is formed only between the semiconductor layer 154 and the source electrode 173 and between the semiconductor layer 154 and the drain electrode 175. In contrast, according to the thin film transistor of FIG. 3, first barrier layers NPL1 and NPL2 are formed on the channel portion CH and the peripheral portion SU, and the first barrier layer NPL1 that comes in contact with the channel portion CH is connected to the first barrier layer NPL2 that comes in contact with the peripheral portion SU.

The first barrier layer NPL1 that comes in contact with the channel portion CH prevents the thickness of the semiconductor layer 154 from becoming non-uniform, and thus uniformity of the electrical characteristics of the thin film transistor can be secured.

The thickness W1 of the first barrier layer NPL1 that comes in contact with the channel portion CH is thinner than the thickness W2 of the first barrier layer NPL2 that comes in contact with the peripheral portion SU. The first barrier layer NPL1 that comes in contact with the channel portion CH may cover the channel portion CH together with the passivation layer 180. The thin film transistor of FIG. 3 is different from the thin film transistor of FIG. 2, in which the passivation layer 180 comes in contact with the channel portion CH of the semiconductor layer 154, on the point that the first barrier layer NPL1 comes in contact with the channel portion CH and the passivation layer 180 comes in contact with the first barrier layer NPL1.

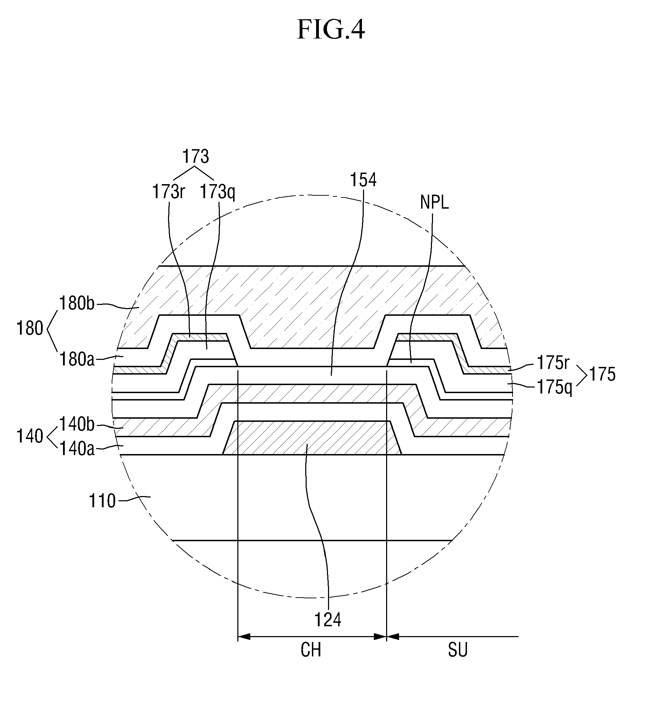

Referring to FIG. 4, the thin film transistor of FIG. 4 is different from the thin film transistor of FIG. 2, in which the second barrier layer 173p or 175p comes in contact with the metal layer 173q or 175q, on the point that the first barrier layer NPL comes in contact with the metal layer 173q or 175q.

The thin film transistor of FIG. 4 may have a structure in which the second barrier layer 173p or 175p is omitted from the thin film transistor of FIG. 2, or a structure in which the first barrier layer NPL and the second barrier layer 173p or 175p are combined with each other.

In the case where the first barrier layer NPL and the second barrier layer 173p or 175p are combined with each other, the thickness of the first barrier layer NPL may be thicker than the thickness of the first barrier layer NPL of FIG. 2. The thickness of the first barrier layer NPL may not exceed a value that is obtained through addition of the thickness of the first barrier layer NPL of FIG. 2 to the thickness of the second barrier layer 173p or 175p.

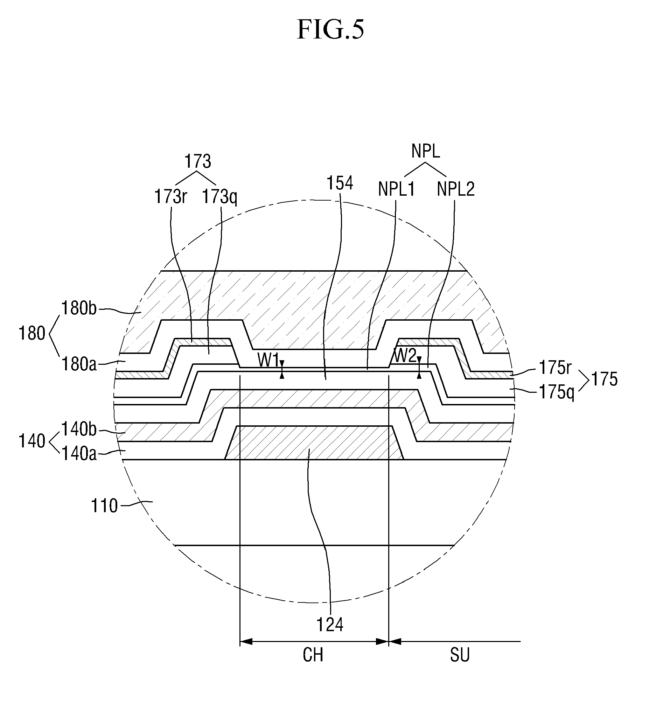

Referring to FIG. 5, the thin film transistor of FIG. 5 is different from the thin film transistor of FIG. 4 on the point that the first barrier layer NPL1 is formed on the channel portion CH. According to the thin film transistor of FIG. 4, the first barrier layer NPL is formed only on the peripheral portion SU, and thus the first barrier layer NPL is formed only between the semiconductor layer 154 and the source electrode 173 and between the semiconductor layer 154 and the drain electrode 175. In contrast, according to the thin film transistor of FIG. 5, the first barrier layer NPL1 is formed even on the channel portion CH. The first barrier layer NPL1 that comes in contact with the channel portion CH is connected to the first barrier layer NPL2 that comes in contact with the peripheral portion SU.

The thickness W1 of the first barrier layer NPL1 that comes in contact with the channel portion CH is thinner than the thickness W2 of the first barrier layer NPL2 that comes in contact with the peripheral portion SU. The first barrier layer NPL1 that comes in contact with the channel portion CH may cover the channel portion CH together with the passivation layer 180. The thin film transistor of FIG. 5 is different from the thin film transistor of FIG. 4, in which the passivation layer 180 comes in contact with the channel portion CH of the semiconductor layer 154, on the point that the first barrier layer NPL1 comes in contact with the channel portion CH and the passivation layer 180 comes in contact with the first barrier layer NPL1.

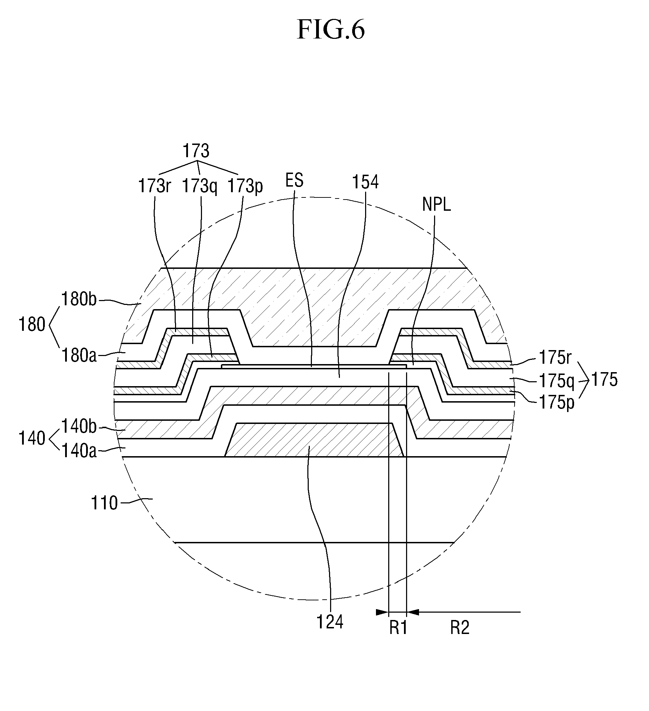

Referring to FIG. 6, the thin film transistor of FIG. 6 is different from the thin film transistor of FIG. 2 that does not include an etch preventing layer ES on the point that the thin film transistor of FIG. 6 includes the etch preventing layer ES.

The etch preventing layer ES is arranged in a region that overlaps the channel portion CH, and comes in contact with the channel portion CH. On the point that the passivation layer 180 comes in contact with the etch preventing layer ES, the thin film transistor of FIG. 6 is different from the thin film transistor of FIG. 2, in which the passivation layer 180 comes in contact with the channel portion CH of the semiconductor layer 154.

The etch preventing layer ES may serve to prevent etching of the channel portion CH of the semiconductor layer 154. The etch preventing layer ES may be formed of a material having the etch rate that is lower than the etch rate of the first barrier layer NPL, the second barrier layer 173p or 175p, the metal layer 173q or 175q, or the capping layer 173r or 175r.

A first region R1 of the first barrier layer NPL may be arranged between the etch preventing layer ES and the second barrier layer 173p or 175p. A second region R2 of the first barrier layer NPL may be arranged between the second barrier layer 173p or 175p and the peripheral portion SU of the semiconductor layer 154. In the second region R2, the etch preventing layer ES is not interposed between the peripheral portion SU of the semiconductor layer 154 and the second barrier layer 173p or 175p.

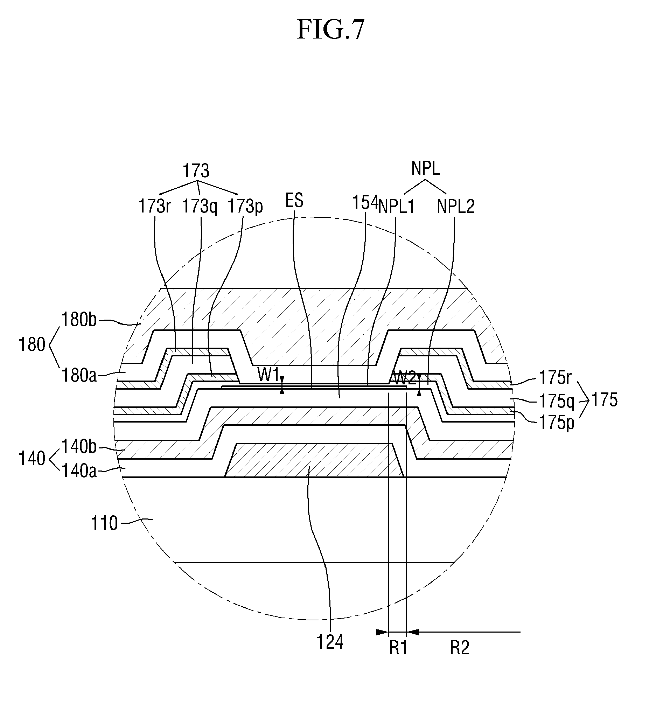

Referring to FIG. 7, the thin film transistor of FIG. 7 is different from the thin film transistor of FIG. 6 on the point that the first barrier layer NPL is formed on the channel portion CH. According to the thin film transistor of FIG. 6, the first barrier layer NPL is formed only on the peripheral portion SU, and thus the first barrier layer NPL is formed only between the semiconductor layer 154 and the source electrode 173 and between the semiconductor layer 154 and the drain electrode 175. In contrast, according to the thin film transistor of FIG. 7, the first barrier layer NPL1 is formed even on the channel portion CH. The first barrier layer NPL1 that comes in contact with the channel portion CH is connected to the first barrier layer NPL2 that comes in contact with the peripheral portion SU.

The thickness W1 of the first barrier layer NPL1 that comes in contact with the channel portion CH is thinner than the thickness W2 of the first barrier layer NPL2 that comes in contact with the peripheral portion SU. The first barrier layer NPL1 that comes in contact with the channel portion CH may cover the channel portion CH together with the passivation layer 180. The thin film transistor of FIG. 7 is different from the thin film transistor of FIG. 6, in which the passivation layer 180 comes in contact with the channel portion CH of the semiconductor layer 154, on the point that the first barrier layer NPL1 comes in contact with the channel portion CH and the passivation layer 180 comes in contact with the first barrier layer NPL1.

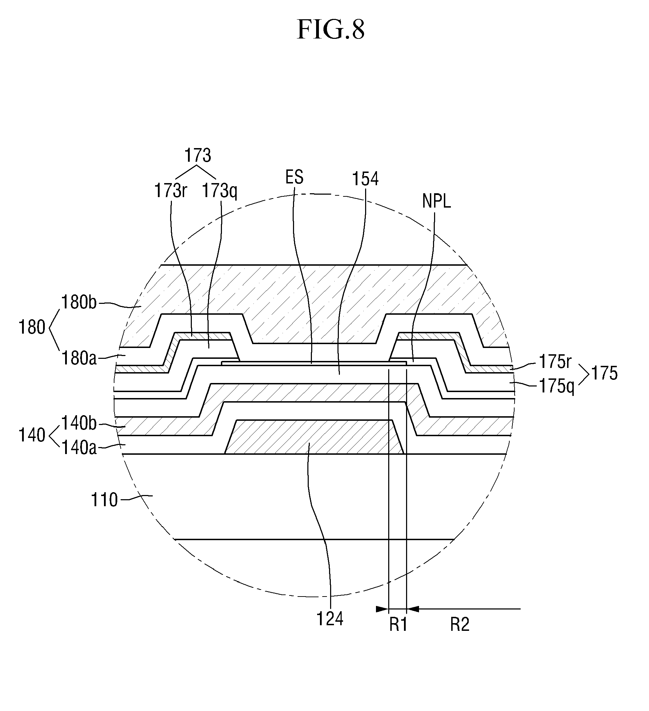

Referring to FIG. 8, the thin film transistor of FIG. 8 is different from the thin film transistor of FIG. 4 which does not include an etch preventing layer ES on the point that the thin film transistor of FIG. 8 includes the etch preventing layer ES.

The etch preventing layer ES is arranged in a region that overlaps the channel portion CH, and comes in contact with the channel portion CH. On the point that the passivation layer 180 comes in contact with the etch preventing layer ES, the thin film transistor of FIG. 8 is different from the thin film transistor of FIG. 4, in which the passivation layer 180 comes in contact with the channel portion CH of the semiconductor layer 154.

A first region R1 of the first barrier layer NPL may be arranged between the etch preventing layer ES and the metal layer 173q or 175q. A second region R2 of the first barrier layer NPL may be arranged between the metal layer 173q or 175q and the peripheral portion SU of the semiconductor layer 154. In the second region R2, the etch preventing layer ES is not interposed between the peripheral portion SU of the semiconductor layer 154 and the metal layer 173q or 175q.

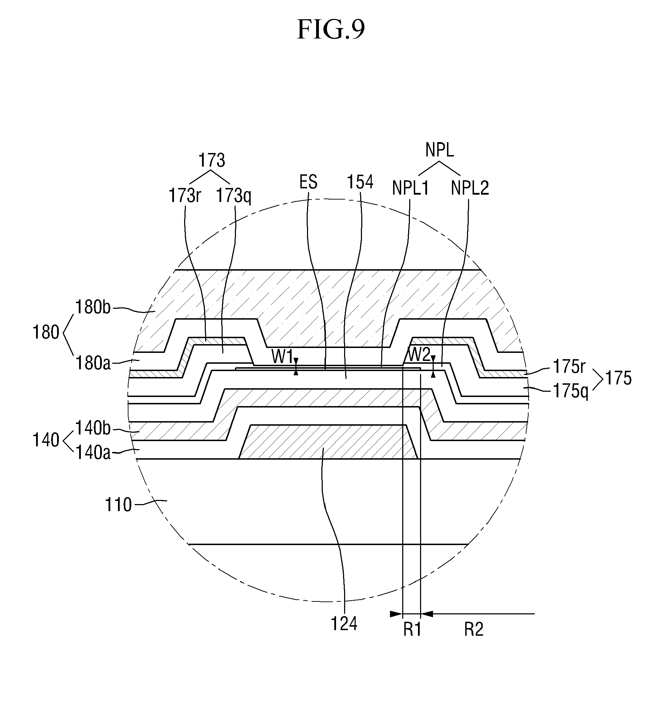

Referring to FIG. 9, the thin film transistor of FIG. 9 is different from the thin film transistor of FIG. 8 on the point that the first barrier layer NPL is formed on the channel portion CH. According to the thin film transistor of FIG. 8, the first barrier layer NPL is formed only on the peripheral portion SU, and thus the first barrier layer NPL is formed only between the semiconductor layer 154 and the source electrode 173 and between the semiconductor layer 154 and the drain electrode 175. In contrast, according to the thin film transistor of FIG. 9, the first barrier layer NPL1 is formed even on the channel portion CH. The first barrier layer NPL1 that comes in contact with the channel portion CH is connected to the first barrier layer NPL2 that comes in contact with the peripheral portion SU.

The thickness W1 of the first barrier layer NPL1 that comes in contact with the etch preventing layer ES is thinner than the thickness W2 of the first barrier layer NPL2 that comes in contact with the peripheral portion SU. The first barrier layer NPL1 that comes in contact with the etch preventing layer ES may cover the channel portion CH together with the passivation layer 180. The thin film transistor of FIG. 9 is different from the thin film transistor of FIG. 8, in which the passivation layer 180 comes in contact with the channel portion CH of the semiconductor layer 154, on the point that the first barrier layer NPL1 comes in contact with etch preventing layer ES and the passivation layer 180 comes in contact with the first barrier layer NPL1.

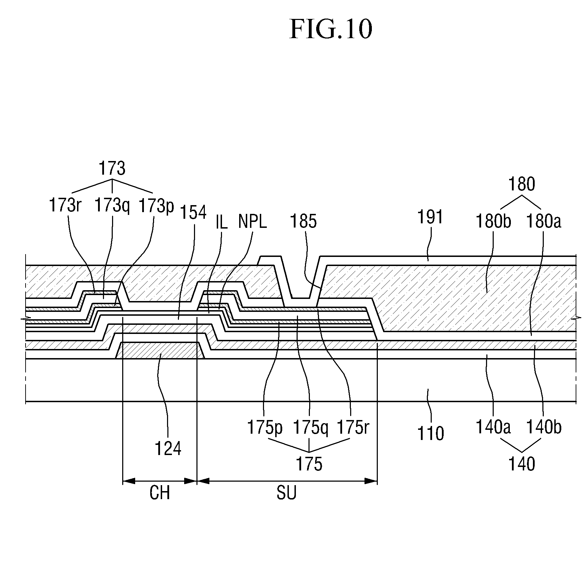

Referring to FIG. 10, the thin film transistor of FIG. 10 is different from the thin film transistor of FIG. 2 which does not include an intermixing layer IL on the point that the thin film transistor of FIG. 10 includes the intermixing layer IL in which a first material and a second material are mixed.

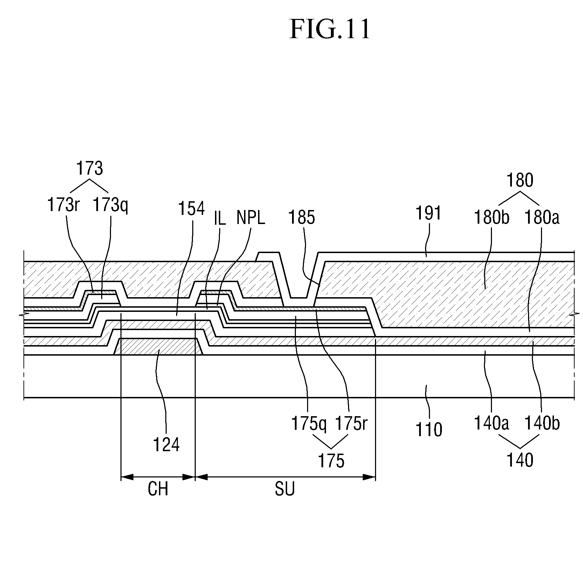

Referring to FIG. 11, the thin film transistor of FIG. 11 is different from the thin film transistor of FIG. 4 which does not include an intermixing layer IL on the point that the thin film transistor of FIG. 11 includes the intermixing layer IL.

The intermixing layer IL may be formed between the first barrier layer NPL of the first material and the semiconductor layer 154 of the second material. The intermixing layer IL has thermal conductivity that is lower than the thermal conductivity of the semiconductor layer 154. For convenience in explanation, if it is assumed that the first material is indium-gallium-zinc oxide (IGZO) and the second material is indium-tin-zinc oxide (ITZO), the intermixing layer IL may be made of a mixture of the indium-gallium-zinc oxide (IGZO) and the indium-tin-zinc oxide (ITZO). As described above, the thermal conductivity of the first material is lower than the thermal conductivity of the second material. The intermixing layer IL in which the first material and the second material are mixed has the thermal conductivity that is lower than the thermal conductivity of the second material. In other words, the thermal conductivity of the semiconductor layer 154 is higher than the thermal conductivity of the intermixing layer IL.

The thermal conductivity of the intermixing layer IL is lower than the thermal conductivity of the second barrier layer 173p or 175p. As described above, the third material has the thermal conductivity that is higher than the thermal conductivity of the first material.

## Claims

1. A thin film transistor comprising:
a semiconductor layer (154);
a first metal oxide layer (NPL) in contact with the semiconductor layer (154) and having thermal conductivity that is lower than the thermal conductivity of the semiconductor layer (154); and
a second metal oxide layer (173p, 175p) in contact with the first metal oxide layer (NPL) and having thermal conductivity that is higher than the thermal conductivity of the first metal oxide layer (NPL).

2. The thin film transistor of claim 1, wherein the thermal conductivity of the second metal oxide layer (173p, 175p) is higher than the thermal conductivity of the semiconductor layer (154).

3. The thin film transistor of claim 1, further comprising a metal layer in contact with the second metal oxide layer (173p, 175p).

4. The thin film transistor of claim 3, further comprising a third metal oxide layer (173r, 175r) having thermal conductivity that is higher than the thermal conductivity of the first metal oxide layer (NPL),
wherein the metal layer is arranged between the second metal oxide layer (173p, 175p) and the third metal oxide layer (173r, 175r).

5. The thin film transistor of claim 1, wherein the first metal oxide layer (NPL) has an etch rate that is higher than the etch rate of the semiconductor layer (154).

6. The thin film transistor of claim 1, wherein the second metal oxide layer (173p, 175p) has an etch rate that is higher than the etch rate of the first metal oxide layer (NPL).

7. The thin film transistor of claim 4, wherein the metal layer has an etch rate that is higher than the etch rate of the third metal oxide layer (173r, 175r).

8. The thin film transistor of claim 4, wherein the third metal oxide layer (173r, 175r) has an etch rate that is higher than the etch rate of the second metal oxide layer (173p, 175p).

9. The thin film transistor of claim 1, wherein the semiconductor layer (154) comprises a channel portion and a peripheral portion that is arranged around the channel portion, and the first metal oxide layer (NPL) contacts the peripheral portion without contacting the channel portion.

10. The thin film transistor of claim 9, further comprising a first metal oxide layer (NPL) that contacts the channel portion (CH), wherein the first metal oxide layer (NPL) that contacts the channel portion (CH) is thinner than the first metal oxide layer (NPL) that contacts the peripheral portion.

11. A thin film transistor comprising:
a semiconductor layer (154);
a first metal oxide layer (NPL) contacting the semiconductor layer (154) and having thermal conductivity that is lower than the thermal conductivity of the semiconductor layer (154); and
a metal layer contacting the first metal oxide layer (NPL).

12. The thin film transistor of claim 11, further comprising a third metal oxide layer (173r, 175r) having thermal conductivity that is higher than the thermal conductivity of the first metal oxide layer (NPL),
wherein the metal layer is arranged between the first metal oxide layer (NPL) and the third metal oxide layer (173r, 175r).

13. The thin film transistor of claim 11, wherein the semiconductor layer (154) comprises a channel portion (CH) and a peripheral portion (SU) that is arranged around the channel portion (CH), and the first metal oxide layer (NPL) contacts the peripheral portion (SU) without contacting the channel portion (CH).

14. The thin film transistor of claim 13, further comprising a first metal oxide layer (NPL) that contacts the channel portion (CH).

15. The thin film transistor of claim 14, wherein the first metal oxide layer (NPL) that contacts the channel portion (CH) is thinner than the first metal oxide layer (NPL) that contacts the peripheral portion (SU).
